# EUROPEAN PATENT APPLICATION

(11) **EP 4 779 678 A1**
(43) Date of publication of application: **22.07.2026**
(21) Application number: 25152467.4
(22) Date of filing: 17.01.2025
(51) Int. Cl.: H01L 21/48, H01L 23/31, H01L 23/498, H01L 23/538, H01L 25/065, H01L 25/07, H01L 25/075, H01L 25/11

(54) **COMPONENT CARRIER AND METHOD FOR MANUFACTURING A COMPONENT CARRIER**

(71) Applicant: AT & S Austria Technologie & Systemtechnik Aktiengesellschaft, 8700 Leoben-Hinterberg (AT)
(72) Inventor: OGGIONI, Stefano Sergio, 8700 Leoben (AT); CASTO, Andrea, 8010 Graz (AT); KIRCHHEIMER, Karl Philipp, 8700 Leoben (AT)
(74) Representative: Donatello, Daniele

(57) **Abstract**

The present invention relates to a component carrier (100) a method for manufacturing thereof, wherein the component carrier (100) comprises a stack (110) comprising a plurality of electrically conductive layer structures (104) and a plurality of electrically insulating layer structures (102). Said stack (110) further comprises a cavity (120) having a bottom wall (122) composed of a plurality of portions (124) having a respective vertical level, and being delimited by one main surface of one of said plurality of electrically conductive layer structures (104) or electrically insulating layer structures (102) composing the stack (110). Additionally, the component carrier (100) comprises a plurality of components (130) provided in said cavity (120), at least two of said components (130) having different heights one to each other and each of said components (130) being associated to one respective portion (124), such that the surfaces of said components (130) opposed to the bottom wall (122) of the cavity (120) are vertically positioned within the vertical extension of the same external layer structures Further additionally, the component carrier (100) comprises an encapsulant material (140) embedding said plurality of components (130).

## Description

### Technical Background

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. At the same time, component carriers shall be mechanically robust and electrically reliable so as to be operable even under harsh conditions.

For example, embedding a plurality of components into at least one cavity, wherein the respective components have different heights, may be challenging.

There may be a need to create a component carrier comprising a cavity and embedding a plurality of components in the cavity, at least two of said components having different heights one to each other, in an efficient, reliable, and robust manner.

In order to achieve the object defined above, a component carrier and a method of manufacturing the component carrier according to the independent claims are provided. The dependent claims describe advantageous embodiments.

### Field of the Invention

The present invention generally relates to a component carrier comprising a stack comprising a plurality of electrically conductive layer structures and a plurality of electrically insulating layer structures, said stack further comprising a cavity having a bottom wall composed of a plurality of portions having a respective vertical level and being delimited by one main surface of one of said plurality of electrically conductive layer structures or electrically insulating layer structures composing the stack. A plurality of components is provided in said cavity, at least two of said components having different heights one to each other and each of said components being associated to one respective portion, such that the surfaces of said components opposed to the bottom wall of the cavity are vertically positioned within the vertical extension of the same external layer structures. Furthermore, an encapsulant material embeds said plurality of components.

Further, the present invention relates to a method for manufacturing a component carrier as described.

According to a first aspect of the present invention, a component carrier is provided, wherein the component carrier comprises a stack comprising a plurality of electrically conductive layer structures and a plurality of electrically insulating layer structures, said stack further comprising a cavity having a bottom wall composed of a plurality of portions having a respective vertical level and being delimited by one main surface of one of said plurality of electrically conductive layer structures or electrically insulating layer structures composing the stack. A plurality of components is provided in said cavity, at least two of said components having different heights one to each other and each of said components being associated to one respective portion, such that the surfaces of said components opposed to the bottom wall of the cavity are vertically positioned within the vertical extension of the same external layer structures. Furthermore, an encapsulant material embeds said plurality of components. Preferably, at least two portions may correspond to respective at least two different vertical levels. Additionally or alternatively, all portions may correspond to different vertical levels on to each other. In an example, the bottom wall of at least one of the portions is delimited by one main surface of one of said plurality of electrically conductive layer structures. Additionally or alternatively, the bottom wall of at least one of the portions is delimited by one main surface of one of said plurality of electrically insulating layer structures.

According to the second aspect of the present invention, a method of manufacturing a component carrier is provided, wherein the method comprises the steps of: providing a stack comprising a plurality of electrically conductive layer structures and a plurality of electrically insulating layer structures, said stack further comprising a cavity having a bottom wall composed of a plurality of portions having a respective vertical level and being delimited by one main surface of one of said plurality of electrically conductive layer structures or electrically insulating layer structures composing the stack. Furthermore, the method comprises providing a plurality of components in said cavity, at least two of said components having different heights one to each other and each of said components being associated to one respective portion, such that the surfaces of said components opposed to the bottom wall of the cavity are vertically positioned within the vertical extension of the same external layer structures. Moreover, the method comprises providing an encapsulant material such that said encapsulant material embeds said plurality of components.

A component carrier according to the first aspect of the present invention is created, in which a plurality of components is at least partially, in particular fully, embedded in a cavity, said cavity having a bottom wall composed of a plurality of portions having a respective vertical level and the heights of the respective plurality of components are different. Due to the different vertical levels of the respective bottom walls of the plurality of portions a plurality of components having respective different heights can be embedded, wherein one extremity of one component and another extremity of another component are positioned within the same external layer structures. Preferably, the encapsulant material may be provided at the vertical level of the stack opposed to the side of the cavity where the bottom wall composed of the plurality of portions is located. Additionally or alternatively, the encapsulant material may be provided at a vertical level, which is defining a sidewall of the cavity. Preferably, at least a portion of a sidewall of the cavity may comprise or consist of the encapsulant material. Further additionally or alternatively, the encapsulant material may be provided at a vertical level, which is defining an association structure, for example, an adhesive material and/or an adhesive structure, which is located at the bottom wall of the cavity. This may bring the advantage of a cost effective solution for the embedding of a plurality of components having different heights one to each other due to the delimitation of the cavity bottom wall by the main surface of one of the (electrically conductive or electrically insulating) layer structures composing the stack, avoiding the formation of cavity(ies) therein, other than the upper layers where the cavity, preferable a plurality of the respective portions, more preferably all the respective portions, is/are formed; taking into consideration the different heights of the plurality of components, even if they may not be perfectly aligned at the side opposed to the bottom wall of the cavity, in particular due to the unlikely or imprecisely matching of the height differences between the components with respect to the layer structures heights, being in any case vertically positioned within the vertical extension of the same external layer structures the needed amount of material from the encapsulant material embedding said plurality of components may be efficiently optimized and/or reduced; on that purpose, a reliably (fully) filling and encapsulating of the plurality of components may be provided: this may originate from the fact that the volume to be filled by the encapsulant material inside the cavity is relatively small, since the volume of the cavity occupied by the plurality of component is comparably large. In an example, the ratio of the sum of the volumes of the plurality of component is at least 80% compared with the total volume of the cavity. Therefore, the volume of the encapsulant material protruding into the cavity may be smaller than 20% compared with the total volume of the cavity. The deeper and/or the larger the cavity in one planar direction is, the more pronounced this effect would be. Completely filling the cavity with encapsulant material may require less encapsulant material due to the geometrical shape of the cavity compared with a cavity having a flat bottom wall, when considering that the maximum depth of the cavity having a bottom wall composed of a plurality of portions and the cavity having a flat bottom wall are the same. Preferably, a plurality of components may be adjacent one to each other (provided in the same cavity). In an example, the encapsulant material may comprise electrically insulating material, for example epoxy resin and/or poly(meth)acrylate. Preferably, the encapsulant material may be the same as the material of an electrically insulating layer structure. In a further example, the electrically insulating layer structure may comprise the encapsulant material. Alternatively, the encapsulant material may be different from the material of the electrically insulating layer structure. In another example, the encapsulating material may be electrically conductive, in particular may comprise electrically conductive material, for example electrically conductive organic polymeric material, e.g. polyaniline and/or poly-3,4-ethylendioxythiophen.

In context of the present application, the term "embedding" may particularly denote that the component is in direct contact with an encapsulant material. Preferably, at least one surface of the component may be in direct contact with the encapsulant material. In particular, the term "fully embedding" may mean that at least three surfaces of a component are in direct contact with the encapsulant material when considering a cross-sectional view. Preferably, one main surface of the component and two sidewalls of the component may be in direct contact with the encapsulant material. More preferably, the at least three surfaces of the component may be fully covered by the encapsulant material. Optionally, at least a portion of a fourth surface of the component may be in direction contact with the encapsulant material. Further optionally, at least one connecting surface or connecting terminal of the component may be in direct contact with the encapsulant material.

In the context of the present application, the term "component carrier" may particularly denote any support structure which is capable of accommodating one or more components thereon and/or therein for providing mechanical support and/or electrical connectivity. A component carrier may also support thermal management, wherein the component carrier may in particular serve as a heat guiding and/or conduction structure, preferably supporting heat dissipation. In other words, a component carrier may be configured as a mechanical and/or electronic and/or thermal (acting) carrier for components. The component carrier may be configured to transmit electromagnetic waves.

In particular, a component carrier may be one of or may be configured as a printed circuit board (PCB), an interposer, in particular an organic interposer, and an IC (integrated circuit) substrate. A component carrier may also be a hybrid board combining different ones of the above-mentioned types of component carriers.

In some embodiments, a component carrier may in particular comprise one or more stacks and/or more than at least two electrically conductive layer structures. A component carrier may, for example, also comprise a solder resist layer structure and/or a protective layer structure. A protective layer structure may also be functionalized as an electrically conductive layer structure for at least one component.

In at least one embodiment, the component carrier may in particular be a laminate-type component carrier. In such an embodiment, the component carrier may in particular be a compound of multiple layer structures which are stacked one above the other and which are connected together by applying a pressing force and/or heat, in particular with simultaneous application of vacuum.

In the context of the present application, the term "printed circuit board" (PCB) may particularly denote a component carrier, in particular a plate-shaped component carrier, which is preferably formed by laminating several layer structures, for instance by applying pressure and/or by the supply of thermal energy. A PCB comprises in particular at least one insulating layer structure.

In at least one embodiment, in particular in a preferred embodiment of a PCB, the PCB is in particular formed by laminating several electrically conductive layer structures with several electrically insulating layer structures. The insulating layer structures may in particular be arranged in between the electrically conductive layer structures, wherein the electrically conductive layer structures and the insulating layer structures may be arranged alternating in stacking direction.

As preferred materials for PCB technology, the electrically conductive layer structures may be made of copper and/or contain at least a certain and defined amount of copper as it is well-known from prior art and usual, whereas the electrically insulating layer structures may comprise resin and/or glass fibers, so-called prepreg or FR4 material. The electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole may either connect the whole stack, (through-hole connections extending through several layers or the entire stack), or the filled hole may connect at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board may in particular be configured for accommodating one or more components on one or both opposing main surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier, in particular an IC substrate. An IC substrate may be, in relation to a PCB, a comparably small component carrier onto which one or more components may be mounted and that may act as a connection medium between one or more chip(s) and a further PCB. For instance, an IC substrate may have substantially the same size as a component (in particular an electronic component) to be mounted thereon (for instance in case of a Chip Scale Package (CSP)). More specifically, an IC substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections may in particular be arranged within the IC substrate and may be used to provide electrical, thermal and/or mechanical connections of housed components or unhoused components (such as bare dies), particularly of IC chips, with a printed circuit board or intermediate printed circuit board. A "substrate" in the context of the present application in particular facilitates electrical connections and/or dissipating heat and/or offering mechanical strength. Thus, the term "substrate" is in particular used as a synonym of "IC substrate" in the context of the present application. It has to be noted that the term "substrate" may in particular not been mixed up with the term "substrate" as it is usually used in the wafer context in which "substrate" usually means the substrate material used in wafer manufacturing as a base material upon which devices or circuits are built and which forms the foundational layer that supports the electronic or photonic structures integrated into a wafer. This is not what is meant with "substrate" in the context of the present application.

A dielectric part of a substrate (of an IC substrate) may be composed of resin with reinforcing particles (such as reinforcing spheres, in particular glass spheres).

In the context of the present application, the term "interposer" may in particularly denote a physical structure configured to bridge at least one electrical connection. An interposer may in particular be a physical interface layer structure. An interposer may in particular be configured to spread an electrical connection to a wider pitch and/or to bridge between different connection types. An interposer can be made of various materials, including silicon, glass, or organic substrates. An IC substrate or interposer may in particular comprise or consist of an inorganic layer structure or at least a layer of glass, silicon (Si) and/or a photo-imageable or dry-etchable organic material like epoxy-based build-up material (such as epoxy-based build-up film) or polymer compounds (which may or may not include photo- and/or thermosensitive molecules) like polyimide or polybenzoxazole as electrically insulating material.

In the context of the present application, the term "inorganic layer structure" may particularly denote a layer structure which comprises inorganic material, such as an inorganic compound. In particular, dielectric material of the inorganic layer structure or even the entire inorganic layer structure may be made exclusively or at least substantially exclusively from inorganic material. In another embodiment, the inorganic layer structure may comprise inorganic dielectric material and additionally another dielectric material. An inorganic compound may be a chemical compound that lacks carbon-hydrogen bonds or a chemical compound that is not an organic compound. In an example, the inorganic layer structure may comprise glass, for example silicon base glass, in particular solder lime glass, and/or boro-silicate glass and/or alumo-silicate glass and/or lithium silicate glass and/or alkaline free glass. In another example, the inorganic layer structure may comprise ceramic material, for example aluminum nitride and/or aluminum oxide and/or silicon nitride and/or boron nitride and/or sapphire and/or zirconia and/or cordierite and/or cordierite and/or steatite and/or forsterite and/or yttria and/or tungsten comprising ceramic material. Yet, in another example, the inorganic layer structure may comprise semi-conducting material, for example silicon and/or germanium and/or silicon oxide and/or germanium oxide and/or silicon carbide and/or gallium nitride and/or gallium arsenide and/or indium phosphide. In a further embodiment, the inorganic layer structure may comprise (elemental) metal and/or metal alloys, for example, copper and/or tin and/or bronze. Yet in another embodiment, the inorganic layer structure may comprise inorganic material, which is not listed in the above-mentioned example, such as: MoS₂, CuGaOz, AgAlO₂, LiGaTe₂, AgInSe₂, CuFeS₂, BeO.

In the context of the present application, the term "component" may particularly denote an electronic component which is configured to be mounted on and/or to be embedded into a component carrier, wherein the component may further in particular be configured to be electrically connected to the component carrier. A component can be an inorganic component (such as, for example, a semiconductor component) or a component comprising inorganic material and/or metal material and/or a combination thereof or consisting thereof.

A component may in particular be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminum oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microoptoelectromechanical system (MOEMS), a microprocessor, a capacitor, a resistor, an inductance, a battery, a switch, a camera, an antenna, a logic chip, and an energy harvesting unit. However, in addition or alternatively, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be an IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component. Additionally or alternatively, the component may comprise a polymer waveguide and/or (optical) lenses and/or collimators and/or ferrules.

In the context of the present application, the term "stack" may particularly denote an arrangement of multiple planar layer structures which are mounted in parallel on top of one another. Some of the layer structures of the stack described herein may be stacked directly onto each other, that means with not further layer structure or component in between or indirectly, wherein between other layer structures described in the present application, further layer structures or components or the like may be arranged which are not described in the present application unless explicitly described to the contrary.

In the context of the present application, the term "electrically conductive layer structure" may particularly denote a layer structure which is electrically conductive. An electrically conductive layer structure may in particular comprise one or more conductive pathways, tracks, and/or signal traces and/or through connections such as vias and holes and/or interconnection structures for interconnection of the layers and/or for connection with other elements and/or components such as bumps, pillars or the like and/or nanowires. These electrically conductive structures may for example be etched from copper sheets and may, for example, be laminated onto an electrically non-conductive or electrically insulating layer structure, which the component carrier may comprise additionally in at least one embodiment. Additionally or alternatively, the electrically conductive layer structure may be produced by an additive process, for example SAP or mSAP, wherein SAP stands for "Semi-Additive Process" and mSAP denotes the "modified Semi-Additive Process", wherein both processes SAP and mSAP are well-known from prior art. In an example, the SAP and/or mSAP may comprise acidic conditions and/or alkaline conditions.

In at least one embodiment, the at least one electrically conductive layer structure of the component carrier comprises at least one of the following group consisting of: copper, aluminum, nickel, silver, gold, palladium, tungsten and magnesium and/or an alloy comprising at least one material component of the aforementioned group. Although copper is usually preferred, other materials or coated versions thereof are possible as well, in particular coated with supra-conductive material or conductive polymers, such as graphene or poly(3,4-ethylenedioxythiophene) (PEDOT) or polyaniline, respectively.

In the context of the present application, the term "electrically insulating layer structure" may denote a layer structure which is electrically non-conductive.

The at least one electrically insulating layer structure may comprise at least one of the following group consisting of: a resin or a polymer, such as epoxy resin, cyanate ester resin, benzocyclobutene resin, bismaleimidetriazine resin, polyphenylene derivate (for example based on polyphenylenether, PPE), polyimide (PI), polyamide (PA), liquid crystal polymer (LCP), polytetrafluoroethylene (PTFE) and/or a combination thereof. Reinforcing structures such as webs, fibers, (hollow) spheres or other kinds of filler particles, for example made of glass (multilayer glass) in order to form a composite, could be used as well. A semi-cured resin in combination with a reinforcing agent, for example fibers impregnated with the above-mentioned resins, is called prepreg and may also be used. These prepregs are often named after their properties for example FR4 or FR5, which describe their flame-retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating layer structures.

In the context of the present application, the term "layer structure" may particularly denote a continuous layer, a patterned layer or a plurality of nonconsecutive islands within a common plane. A layer structure can comprise at least one protruding element such as, for example, one or more solder bumps, copper bumps, pillars or other bonding structures like these, wherein the at least one protruding element may in particular protrude beyond the surface of a layer structure.

In at least one embodiment of the present invention, at least one body and/or layer structure of the component carrier may comprise a main surface, wherein in the context of the present application, the term "main surface" of a body or a layer structure may particularly denote one of the two largest opposing surfaces of the body or the layer structure or the outermost layer (structure) of the component carriers. The main surfaces may be connected by circumferential side walls. The thickness of a body or a layer structure, such as a stack, may be defined by the distance between the two opposing main surfaces, in particular in direction perpendicular to the extension of the main surface, in particular perpendicular to its planar extension.

In the context of the present application, the term "thickness direction" or "stacking direction" may particularly refer to a direction perpendicular to a planar extension of at least one layer structure of the stack.

In the context of the present application, the term "cavity" may particularly denote a recess or hollow space having been created within a structure of the component carrier, in particular in between parts and/or components and/or layers of the component carrier.

At least one cavity of the component carrier may have been created at least partially or completely by a mechanical manufacturing step, for instance by drilling and/or milling, in particular by laser drilling and/or mechanical drilling. Additionally or alternatively, an etching process may be used to create at least one cavity of the component carrier at least partially. However, material removal by laser drilling is preferred. This kind of material removal allows very precise and efficient material removal without significant introduction of mechanical stress or other significant unwanted effects into the surrounding material. Further, the resulting surface properties enable the establishment of high-quality electrical connections. In addition, laser material removal allows to handle various materials and a plurality of different cavity sizes in a very easy manner.

In the context of the present application, the term "associated" may mean that two things are related with another, in particular connected to another or in contact with each other. In an example, a first component may be in direct or indirect contact (for example by an adhesive material) with a first portion, in particular with the bottom wall of the first portion. Additionally, the first component may be in indirect contact for example by a further adhesive material with the first portion, in particular with the bottom wall of the first portion. In another example, a second component may be in direct or indirect contact (for example by an adhesive material) with a second portion, in particular with the bottom wall of the second portion. Additionally, the second component may be in indirect contact for example by a further adhesive material with the second portion, in particular with the bottom wall of the first portion. Preferably, the first component may be free from contact to the second portion and/or the second component may be free from contact to the first portion.

In the context of the present application, the term "being adjacent one to the other" may particular denote that a first component and a second component are at least partially located in the same vertical level regarding thickness direction and are located in lateral close proximity next to each other. In an example, the first component and the second component may be in direct lateral proximity to each other, defining at least one common boundary interface. In another example, the first component and the second component may be laterally separated, in particular spaced, with each other, for example only by an electrically insulating layer structure and/or an encapsulant material. In a further example, the first component and the second component may be associated to the same portion. Still in another example, the first component may be associated to a first portion whereas the second component may be associated to a second portion, while being in close proximity to each other. In a further example, the term "being adjacent one to the other" may exclude that the first component and the second component are stacked one above the other in stacking direction.

In the context of the present application, the term "height" may denote the thickness of the component (in stacking direction), in particular the maximum thickness of the component. In an example, the height may be determined by the distance between the external surface and the opposed external surface of the component in stacking direction. In another example, the height may be determined by the distance between of the component pads and the opposed (bottom surface) regarding stacking direction or the distance between of the component pads located on one side of the component and the component pads located on the opposed other side regarding stacking direction.

In the context of the present application, the term "external layer structures" may denote the outermost layer structures defining the cavity in regard to stacking direction. According to one embodiment, the most external layer structure may be an electrically insulating layer structure regarding stacking direction. Alternatively or additionally, the most external layer structure may be an electrically conductive layer structure in regard to stacking direction.

In the context of the present application, the term "the surfaces of said components opposed to the bottom wall of the cavity are vertically positioned within the vertical extension of the same external layer structures" may denote that the vertical level of a respective surfaces of the components opposed to the respective bottom walls provided in the respective portions are located such that they are all located in proximity of the exposed surface of the component carrier. In an example, the same external layer structures may comprise an electrically insulating layer structure and another (vertical) adjacent electrically insulating layer structure in closest proximity to the exposed profile of the cavity. In another example, the external layer structures may be defined as a plurality of (alternatively stacked) electrically conductive and/or electrically insulating layer structures at the exposed profile of the cavity; in particular, said electrically conductive and/or electrically insulating layer structure(s) at the exposed profile of the cavity are stacked to further electrically conductive and/or electrically insulating layer structure(s) defining the cavity, more in particular said further electrically conductive and/or insulating layer structure(s) defining at least one half, preferably at least three-quarter, more preferably 80% of the cavity height in the stack direction, then decreasing the needed encapsulant material (of the encapsulant layer structure) above the plurality of components.

### Description of Exemplary Embodiments

According to a preferred embodiment of the present invention, the plurality of portions defines a stepped cavity bottom wall. In an example, the at least two portions each having a bottom wall located at different respective vertical levels may be (inter)connected with each other by a sidewall portion of the cavity. Said sidewall portion may have a direction parallel to the stacking direction. Additionally or alternatively, the sidewall portion may be inclined to the stacking direction (in a cross sectional view). In another example, the side wall portion may have a straight and/or a curved shape. The stepped cavity bottom wall may further delimit the total volume of the cavity and thus a lower amount of encapsulating material (of the encapsulating layer structure) is needed to fully fill the cavity. Additionally or alternatively, this may increase the design possibility of embedding at least two components having different heights and thus helps saving space and/or volume inside the component carrier resulting in a possible smaller overall component carrier.

According to another embodiment of the present invention, the component carrier comprises an encapsulant layer structure. Preferably, the stack of the component carrier may comprise the encapsulant layer structure or a plurality of encapsulant layer structures. In an example, the encapsulant layer structure may be an external and/or exposed layer structure. Alternatively, an exposed electrically conductive layer structure and/or an exposed electrically insulating layer structure and/or a combination of electrically conductive layer structures and electrically insulating layer structures may cover the encapsulant layer structure. In an example, the encapsulant layer structure may compose an entire layer of the stack. In an example, the encapsulant layer structure may comprise electrically insulating material, for example epoxy resin and/or poly(meth)acrylate. In an example, the encapsulant layer structure may be the same as the electrically insulating layer structure. Alternatively, the encapsulant material may be different than the electrically insulating layer structure. In a different example, the encapsulant layer structure may cover the cavity at at least one vertical side of the cavity. Preferably, the encapsulant layer structure may be located at the opposed side of the cavity, where the bottom wall composed of the plurality of portions is located. For example, the encapsulant layer structure may be free from reinforcing fibres, compared to the electrically insulating layer structure, which comprises reinforcing fibres. Additionally or alternatively, the polymerization degree of the encapsulating layer structure may be different compared to the electrically insulating layer structure. For example, the encapsulating layer structure may comprise not fully cured material, whereas the electrically insulating layer structure may be fully cured when manufacturing the component carrier. This may bring the advantage of simplifying the manufacturing process, in particular this may reduce the required process steps for manufacturing the component carrier.

In an embodiment of the present invention, the encapsulant layer structure comprises the encapsulant material. This may bring the advantage of reliably filling of the cavity, in particular the space between the sidewall of the cavity and the plurality of components. In particular, the cavity may be filled from at least two sides, for example a vertical top side and a lateral side when the stack comprises a plurality of encapsulant layer structures, preferably delimiting the (at least a portion of the circumference of the) cavity. During the embedding process, for example when applying elevated temperature, for example higher than 60 °C, and/or elevated pressure, for example higher than 1.5 bar, the encapsulant material may penetrate into the locally closed by cavity and may fully fill the cavity from a plurality of directions.

According to a further embodiment of the present invention, a deepest of the plurality of portions has the highest surface extension in a planar view. In an example, the cavity may comprise only one portion having a deepest extension in stacking direction. In another example, the cavity comprises at least two portions having the same deepest extension in stacking direction. The combination of the attributes of one cavity portion having the deepest extension in stacking direction in combination with the highest surface extension in planar view may enable to embed a bigger component, for example an active electronic component or other bodies having extensions e.g. being larger than 100 µm, in particular larger than 350 µm, in at least two directions.

In the context of the present application, the term "deepest" may denote a position of the cavity extension far below a surface and/or extending far inward from the exposed surface. The distance from the deepest position of the cavity to the exposed surface may be longer than the distance from another position inside the cavity (not being classified as deepest) to the exposed surface.

According to another embodiment of the present invention, the deepest of the plurality of portions is circumferentially connected to the other portions of the cavity having different vertical levels. In particular, the other portions have a smaller surface extension and/or are at a higher vertical level with respect to the deepest portion. In other words, the deepest of the plurality of portions is surrounded by the other portions as the sun is surrounded by the planets. This may bring the advantage that the encapsulant material flowing in the other portions during the embedding of the respective components may contribute to fill the (higher) volume between the deepest of the plurality of portions and the inserted component. Additionally, a short (inter)connection between the components embedded in the other portions of the cavity and the component embedded in the deepest portion may be provided; thus faster signal transmission can occur and the component carrier may be use for high performance devices.

According to a preferred embodiment of the present invention, an electrically insulating material, in particular the encapsulant material of the encapsulant layer structure, being free from reinforcing fibres is (laterally) located between deepest of the plurality of portions and the other portions of the cavity and/or between respective different other portions of the cavity. This may bring the advantage of simplifying the filling process of the cavity since it is difficult to transport or transfer fibres into the cavity.

According to a further embodiment of the present invention, the opening of the cavity opposed to bottom wall (composed of a plurality of portions) is flush with a main surface of an electrically conductive layer structure or an electrically insulating layer structure.

According to a preferred embodiment of the present invention, the opening of the cavity opposed to bottom wall (composed of a plurality of portions) is close to or located at the exposed main surface of the stack.

According to a further embodiment of the present invention, at least two portions of the bottom wall each having a respective vertical level are co-planar, in particular parallel, aligned. Additionally or alternatively, at least two portions of the bottom wall each having a respective vertical level may be inclined one to each other. In another example, at least one portion may be curved, in particular convex or concave. This may be the result of the process used for the formation of at least one portion in correlation with a main surface of one of said plurality of electrically conductive layer structures or electrically insulating layer structures composing the stack, even if slightly affecting said main surface at said portion, reducing the amount of needed encapsulating material while accepting an irrelevant impreciseness of the cavity.

According to another embodiment of the present invention, the deepest portion is delimited by a main surface of one of the plurality of electrically insulating layer structures. This may be related to a preferred manufacturing process, for example including the removal (i.e. by etching) of part of the electrically conductive layer structure on the bottom surface of the deepest portion, and thus may ensure that the component embedded in the deepest portion may be insulated / may be flush with the main surface of the one of the plurality of insulating structures. Additionally or alternatively, this may simplify the connection process of connecting the connecting terminals of the component with an electrically conductive layer structure, because temporarily during the manufacturing process the main surface of at least one terminal of the component may not be covered or in contact with other material and could be connected to an electrically conductive layer structure.

Alternatively, the deepest portion may be delimited by a main surface of one of the plurality of electrically conductive layer structures, bringing for example to the advantage of a direct electrical connection of the component with the component carrier.

According to a further embodiment of the present invention, at least one of the other portions is delimited by a main surface of one of the plurality of electrically conducting layer structures. In particular, all other portions may be delimited by a main surface of one of the plurality of electrically conductive layer structures. In an example, all other portions may be in direct contact with (separate) electrically conductive layer structures located on the same vertical level (regarding stacking direction) of the stack. In another example, all other portions may be in direct contact with (separate) electrically conductive layer structures located on different vertical levels (regarding stacking direction) of the stack. Still in a further example, one of the other portions may be in direct contact with an electrically conductive layer structure, whereas a different one of the other portions may be in direct contact with an electrically insulating layer structure of the stack. This may be related to a preferred manufacturing process (for example laser perforation/ablation or routing using the electrically conductive layer structure as the stop layer) and may enable the reliably define the depth of the other portions of the cavity and can also be used for the electrical connection of the inserted component with the component carrier.

Alternatively, the other portions may be delimited by a main surface of one of the plurality of electrically insulating layer structures, bringing for example to the advantage of an insulation of the inserted component.

According to a preferred embodiment of the present invention, the cavity has an irregular shape in planar view. In particular, the cavity may have an irregular planar shape in planar view. In an example, the cavity may have a distorted regular shape.

According to another embodiment of the present invention, the cavity has a stepped shape in planar view. In particular, the cavity may have an irregular stepped planar shape in planar view. In an example, the length or width of at least one step may be different one to the other steps of the shape considering the planar main extension of the component carrier. In another example, the portions of the cavity creating the stepped planar shape in planar view may comprise a rounded edge portion. This may bring the advantage of optimizing the shape of the cavity in order to reduce, in particular minimize, the amount of encapsulant material to be used in order to ensure a reliable and full embedding of the components in the cavity.

According to a further embodiment of the present invention, the cavity in planar view defines a central core from that at least one branch merges. Preferably, the central core may comprise the deepest portion and the at least one branch may comprise at least one of the other portions. Due to the fact that the other portions are associated to the central core, this may bring the advantage that the branches acts as flowing channels of encapsulant material around the core during the embedding of the respective components, enhancing the filling reliability of the (higher) volume to fill in the core. Additionally, this may bring to the advantage of simplifying the connection between the component embedded in the central core and the component(s) embedded in the at least one branch. In an example, a plurality of component may be associated to one branch. Said plurality of components in the branch may be connected in series or parallel to the component associated to the central core.

According to a preferred embodiment of the present invention, at least one of the components in the at least one of the other portions comprises a capacitor and/or a bridge. In an example, all components in the other portions may comprise a capacitor. In another example, the at least one component may be a capacitor. This may bring the advantage of adjusting the potential in an easy manner. Additionally or alternatively, at least one of the component in the at least one of the other portions may be different than a capacitor or a bridge, for example a resistor. This may enable to create a component carrier having different functions and/or different components embedded and preferably interconnected with each other in an easy and reliable way.

According to another embodiment of the present invention, at one of the components in the deepest of the plurality of portions comprises a chip and/or an interposer and/or a block. In an example, only one chip or an interposer or a block may be embedded in the deepest of the plurality of portions. In another example, only one capacitor or resistor may be embedded in the deepest of the plurality of portions. Alternatively, at least two of a chip or an interposer or a block or a combination thereof may be embedded in the deepest of the plurality of portions. Preferably, the two components may be in direct contact with each other. In an example, the block may comprise or consist of a thermally conductive material having a thermal conductivity higher than 50 W/mK. Since an interposer or a chip or a block may have large extensions in stacking direction, the deepest of the plurality of portions can host the component and reliably embed the component without the using a large amount of encapsulant material. Additionally or alternatively, further functionality may be imparted to the component carrier.

According to a further embodiment of the present invention, the space between one of the other portions and the respective one of the plurality of components is different than the space between the deepest of the plurality of portions and one of the plurality of components in said portion. In an example, the space, in particular the (shortest) distance of the space, between the lateral walls of the other cavity portion and the respective lateral walls of the components may be different, in particular greater, than space, in particular the (shortest) distance of the space, between the lateral walls of the deepest cavity portion and the respective lateral walls of the component(s). In another example, the space, in particular the (shortest) distance of the space, between the bottom walls of the other cavity portions and the respective bottom walls of the components may be different, in particular greater, than space, in particular the (shortest) distance of the space, between the bottom wall of the deepest cavity portion and the respective bottom wall of the component(s). In a further example, the average value of the distances of the lateral walls and/or the bottom walls of the other portions to the respective components may be different, in particular smaller or greater, to the average value of the distances of the lateral wall(s) and/or the bottom wall of the deepest portions to the respective components. This may result in the circumstance that the volume of encapsulant material may be different between the different other portions and the respective components and/or the deepest portion and the respective component, promoting the encapsulant material flowing toward specific directions providing the proper volumetric compensation of the required encapsulant material at specific portions through the specific design / dimensional characteristics of the component vs the respective cavity portion.

According to a preferred embodiment of the present invention, a stepped portion is provided between the lateral wall and the bottom of the cavity, in particular said stepped portion being delimited by one main surface of an insulating structure. In an example, the stepped portion may be associated to at least one of the other (of the plurality of) portions of the cavity. In another example, the stepped portion may be associated to the deepest portion of the cavity. This step portion is the footprint of the kind of used process for the cavity formation.

According to another embodiment of the present invention, said stepped portion comprises a protrusion extending into the cavity or a recess extending from the cavity. In example, at least one of the plurality of the electrically conductive layer structures may comprise a protrusion extending into the cavity; The protrusion may be the footprint of a process step where the cavity is provided subtracting the majority of a layer structure, preferably of a conductive layer structure, to form the bottom of the cavity (i.e. through mechanical routing and/or chemical etching). This may simplify the manufacturing process electrically connecting of the component to the electrically conductive layer structures. In another example, at least one of the plurality of the electrically insulating layer structures may comprise a recess extending from the cavity. The recess extending from the cavity may be the footprint of a process step where the cavity is formed through the provision and the subsequent removal of a temporary layer (resulting in the recess); said recess may be fully filled with the encapsulant material of the encapsulant layer structure. The encapsulant material embedding the component inside the cavity may also comprise an anchoring structure at the stepped portion which increases the mechanical stability and/or integrity of the stack.

According to a further embodiment of the present invention, at least two between the plurality of electrically conductive layer structures and/or the plurality of electrically insulating layer structures where the cavity extends have different thicknesses one to each other, in particular said at least two layer structures being either (electrically) insulating or (electrically) conductive layer structures. In an example, the thickness in stacking direction of one of the electrically conductive layer structure may be in the range from 1 µm to 10 µm, whereas the thickness in stacking direction of another of the electrically conductive layer structure may be in the range from 11 µm to 50 µm. In a further example, the thickness in stacking direction of one of the electrically conducting layer structure may be in the range from 1 µm to 20 µm, whereas the thickness in stacking direction of another of the electrically conducting layer structure may be in the range from 21 µm to 100 µm. In another example, the thickness in stacking direction of one of the electrically insulating layer structure may be in the range from 1 µm to 20 µm, whereas the thickness in stacking direction of another of the electrically insulating layer structure may be in the range from 21 µm to 100 µm. Still in a further example, the thickness in stacking direction of one of the electrically insulating layer structure may be in the range from 1 µm to 100 µm, whereas the thickness in stacking direction of another of the electrically insulating layer structure may be in the range from 101 µm to 1000 µm. This may bring the advantage of a proper thickness definition of the stacked layer structures so that the several (stacked layer structure) portions result in a height being closer, in particular (slightly) larger than the thickness of a component suitable for accommodating a component. Additionally or alternatively, the vertical level of the electrically conductive layer structure in the stack can be easily adjusted and thus enables to define the vertical level of the bottom wall of the deepest cavity portion and/or the bottom walls of the other cavity portions in a reliable and easy way.

According to a preferred embodiment of the present invention, vertical connections are provided in the component carrier, a plurality of said vertical connections being electrically connected to a connection surface or a connection terminal of a respective one of the plurality of components, wherein at least one of the vertical connections connected to the connection surface or connection terminal of one of the plurality of components has an extension, in particular a volume, in a planar view and/or in cross sectional view, different than the respective extension of another one of the vertical connections connected to the connection surface or connection terminal of another one of the plurality of components. In an example, the vertical connections may comprise vias or electrically conductive structures. In another example, the vertical connections may be configured for transmitting electrical signal and/or current. Preferably, said vertical connections may pass through at least one of the plurality of electrically insulating layer structure. Optionally, at least one of the plurality of electrically insulating layer structures may comprise or consist of photoimageable material. Preferably, the connection surface or connection terminal may comprise an electrode or pad. A preferred manufacturing method comprising a laser tool may be used for the formation of the vertical connections. Additionally or alternatively, another electromagnetic wave source, for example a UV light, may be used for the formation of the vertical connections. In a preferred example, the (laser) vias may be a hole or a volume filled with electrically conductive material, for example copper. For example, the resulted (laser) vias may be the footprint of the method, since the (laser) vias are connected to one of the plurality of electrically conductive layer structures located at one vertical level regarding stacking direction. Additionally, the (laser) vias may be connected to respective component which have connection terminals or connection surfaces at different vertical levels regarding stacking direction. Due to the formation of the (laser) vias within the same process step connecting respective components having their connection terminals or connection surfaces at different vertical levels the shape of a (laser) via connecting one component may be different to the shape of another (laser) via connecting another component. In an example, the difference in shape of the (laser) vias one to each other may be at the respective extremity of the vias in stacking direction. When using the manufacturing method using photoimageable material it may be not necessary to use a laser tool. Thus the formation of the vias may be less aggressive and may not damage the component, in particular the connection terminal or the connection surface of the component.

According to another embodiment of the present invention, the cavity is prefilled with an adhesive material connecting at least one of the plurality of components. In an example, the adhesive material may comprise an epoxy based resin. In another example, the adhesive material may be a temporary liquid material and/or a solid material. This may bring the advantage of spatially holding the component in place before embedding with the encapsulant material occurs. This may result in a more precise positioning of the component in the cavity.

According to a preferred embodiment if the present invention, the method of manufacturing the component carrier comprises forming the cavity by a mechanical drilling process and/or a mechanical routing and/or a laser process and/or a fluid jet cutting process. In an example, the different portions of the cavity may be formed by one of the aforementioned processes. In another example, the respective different portions of the cavity may be formed by different of the aforementioned processes. In a further example, the different portions of the cavity may be simultaneously or consecutively formed by the same one of the aforementioned processes. Still in a further example, the different portions of the cavity may be simultaneously or consecutively formed by different of the aforementioned processes. Preferably, the fluid jet cutting process may comprise a water jet cutting unit. This may bring the advantage of creating the cavity having a bottom wall composed of a plurality of portions each having a respective vertical level in a fast and/or easy and/or precise manner.

According to a further embodiment of the present invention, the method of manufacturing the component carrier comprises interconnecting the plurality of portions to create the cavity by the mechanical drilling process and/or the mechanical routing and/or the laser process and/or the fluid jet cutting process. This may bring the advantage of creating at least one other portion and interconnecting the at least one other portion to the deepest portion within one process step.

According to a further embodiment of the present invention, the method of manufacturing the component carrier comprises forming each of the portions having different levels in respective manufacturing steps. Manufacturing the cavity in respective manufacturing steps may bring the advantage that the cavity portions associated to the other portions can be pre-manufactured in at least one layer, where the portions of the cavity shall be located. Optionally, the cavity portion associated to the deepest portion can be pre-manufactured in the same at least one layer in which the cavity portions associated to the other portions are pre-manufactured. Preferably, the portions associated to the other portions may extend through the entire thickness regarding stacking direction of the at least one layer. Additionally, the cavity associated to the deepest portion can be pre-manufactured in at least one other layer, where the portion of the cavity shall be located. Thereafter, the pre-manufactured respective layers are stacked one above the other and connected to create the cavity (having a bottom wall composed of a plurality of portions each having a respective vertical level). This may bring the advantage of creating the depth of the different portions of the cavity in a precise manner, since the different portions can be separately created.

The preferred embodiments presented with reference to a component carrier according to the first aspect of the present invention and its advantages apply correspondingly to a method according to the second aspect of the present invention.

Further features of the invention are shown in the claims, the figures, and the description of the figures. All the features and combinations of features mentioned above in the description as well as the features and combinations of features mentioned below in the description of the figures and/or shown alone or in combination in the figures can be used not only in the combination as indicated or shown in each case, but also in other combinations or on their own so far it can technically be realized.
Figure 1 illustrates a cross-sectional view of a component carrier according to an exemplary embodiment.
Figure 2A to Figure 2C illustrate cross-sectional views of structures obtained during carrying out a first sequence of a method of manufacturing a component carrier according to an exemplary embodiment of the invention.
Figure 3A to Figure 3C illustrate cross-sectional views of structures obtained during carrying out a second sequence of a method of manufacturing a component carrier according to an exemplary embodiment of the invention.
Figure 4A to Figure 4C illustrate cross-sectional views of structures obtained during carrying out a third sequence of a method of manufacturing a component carrier according to an exemplary embodiment of the invention.
Figure 5A to Figure 5B illustrate cross-sectional views of structures obtained during carrying out a fourth sequence of a method of manufacturing a component carrier according to an exemplary embodiment of the invention.
Figure 5C and Figure 5D illustrate a magnified view of Figure 5B.
Figure 6A to Figure 6C illustrate cross-sectional views of structures obtained during carrying out a fifth sequence of a method of manufacturing a component carrier according to an exemplary embodiment of the invention.
Figure 7A to Figure 7D illustrate cross-sectional views of structures obtained during carrying out another method of manufacturing a component carrier according to an exemplary embodiment of the invention.
Figure 8A to Figure 8D illustrate cross-sectional views of structures obtained during carrying out a further method of manufacturing a component carrier according to an exemplary embodiment of the invention.
Figure 8E illustrates a top view of a component carrier according to an exemplary embodiment.

### Detailed Description

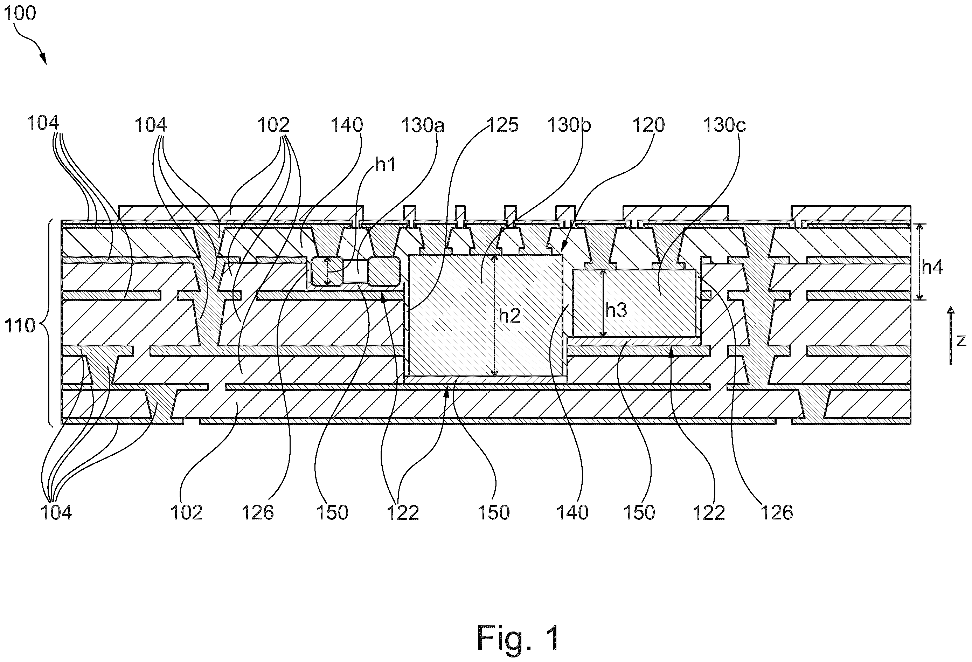

Figure 1 shows an example of a component carrier 100 according to the first aspect of the present invention. The component carrier 100 comprises a stack 110 comprising at least one, in particular at least two, more in particular a plurality of, electrically insulating layer structure 102 and at least one, in particular at least two, more in particular a plurality of, electrically conductive layer structure 104. Preferably, the stack 110 may comprise at least one encapsulant layer structure 140. The stack 110 further comprises a cavity 120 having a bottom wall 122 composed of a plurality of portions 125, 126 having a respective vertical height. The cavity 120 and/or the plurality of portions 125, 126 of the shown component carrier 100 is/are delimited by one main surface of one of the plurality of electrically conductive layer structures 104 composing the stack 110. Three components 130a, 130b, 130c are provided in the cavity 120, having different heights h one to each other, each one associated to one respective portion 125, 126, such that the surface of said components 130 opposed to the bottom wall 122 of the cavity 120 are vertically positioned within the vertical extension h4 of the same external layer structures 102, 104. The encapsulant material of the encapsulant layer structure 140, embeds the plurality of components 130a, 130b, 130c. Preferably, the electrically conductive layer structures 104 and the electrically insulating layer structures 102 and the encapsulant layer structure 140 may be layered one above the other in stacking direction Z and may be mechanically connected one to each other. In an example, the electrically conductive layer structure 104 may comprise copper and/or aluminium, and/or nickel and/or silver and/or titanium and/or gold. In another example, the electrically conductive layer structure 104 may comprise a surface finish, for example ENIG and/or tin. Still in a further example, the electrically conductive layer structure 104 may comprise electrically conductive vertical connections, for example metal filled mechanical through holes and/or metal filled laser vias. In a further example, the electrically insulating layer structure 102 and/or the encapsulant layer structure 140 may comprise a polymeric material, in particular an organic polymeric material, for example an epoxy resin and/or a poly (meth)acrylate resin. In another example, at least one electrically insulating layer structure 102 may comprise mechanical reinforcing material, for example glass spheres and/or glass fibres, and/or may comprise a solder resist material. In an example, the electrically insulating layer structure 102 may be a layer of prepreg or a core layer. In another example, the encapsulant layer structure 140 may be free from glass fibres. Additionally or alternatively, the electrically insulating layer structure 102 and the encapsulant layer structure 140 may comprise the same material. Optionally, the electrically insulating layer structure 102 and the encapsulant layer structure 140 may have been cured at different stages. For example, the encapsulant layer structure 140 may have been cured during the encapsulation of the components 130 a, 130b, 130c, whereas the electrically insulating layer structure 102 was fully cured before the formation of the cavity 120. Alternatively, the encapsulant layer structure 140 and at least one of the electrically insulating layer structure 102 may be not fully cured after the formation of the cavity 120. In another example, the electrically insulating layer structure 102 may comprise the encapsulant material 140, in particular the encapsulant layer structure 140. As can be seen in Figure 1, each of components 130a, 130b, 130c has a different height h. For example, the first component 130a may have a height h1, the second component 130b may have a height h2 and the third component 130c may have a height h3, wherein h1 being different to h2 and h3 and wherein h2 also being different to h3. Alternatively, at least two components 130 may have the same height and/or at least two components have different heights. In a further example, at least one of the components 130 may be an active component and/or a passive component. Preferably, the respective component 130a, 130b, 130c may be associated to one respective portion 125, 126, such that the surfaces of the components 130a, 130b, 130c opposed to the bottom wall 122 of the cavity 120 are vertically positioned within the vertical extension h4 of the same external layer structures 102, 104. In an example, the extension in stacking direction Z of plurality of layer structures composing the vertical extension h4 of the same external layer structures 102, 104 may be smaller than the extension in stacking direction Z of the rest of plurality of layer structures of the stack 110. In Figure 1, a (main) surfaces of the first component 130a, a (main) surfaces of the second component 130b and a (main) surfaces of the third component 130c are positioned within the vertical extension h4 of the same external layer structures, in particular within two adjacent electrically insulating layer structures 102. In a preferred embodiment, at least two between the plurality of electrically conductive layer structures 104 and/or the plurality of electrically insulating layer structures 102 where the cavity 120 extends have different thicknesses regarding stacking direction Z one to each other, in particular said at least two layer structures being either electrically insulating or electrically conductive layer structures. In particular, the thickness of the electrically insulating layer structure 102 may be different than the thickness of the encapsulant layer structure 140 regarding stacking direction Z. Additionally or alternatively, at least two between the plurality of electrically conductive layer structures 104 and/or the plurality of electrically insulating layer structures 102 where the cavity 120 extends have the same thicknesses regarding stacking direction Z one to each other, in particular said at least two layer structures being either electrically insulating or electrically conductive layer structures. In particular, the thickness of the electrically insulating layer structure 102 may be the same as the thickness of the encapsulant layer structure 140 regarding stacking direction Z. In another embodiment, vertical connections are provided in the component carrier 100, a plurality of said vertical connections being electrically connected to a connection surface of a respective one of the plurality of components 130a, 130b, 130c, wherein at least one of the vertical connections connected to the connection surface of one of the plurality of components 130 has an extension, in a planar view and/or cross sectional view, different than the respective extension of another one of the vertical connections connected to the connection surface of another one of the plurality of components 130a, 130b, 130c. In an example, the height and/or the volume, of the respective vertical connections may be different. Preferably, the cavity 120 may comprise an adhesive material 150 connecting at least one of the plurality of components 130 with the bottom wall 122 of the portion 125, 126. In an example, the adhesive material 150 may comprise an epoxy resin and/or a (meth)acrylate resin. In another example, the adhesive material 150 may be an electrically insulating material. Alternatively, the adhesive material may be an electrically conductive material. Additionally or alternatively, the (composition of the) adhesive material 150 may be different to the electrically insulating layer structure 102 and/or the encapsulant material 140.

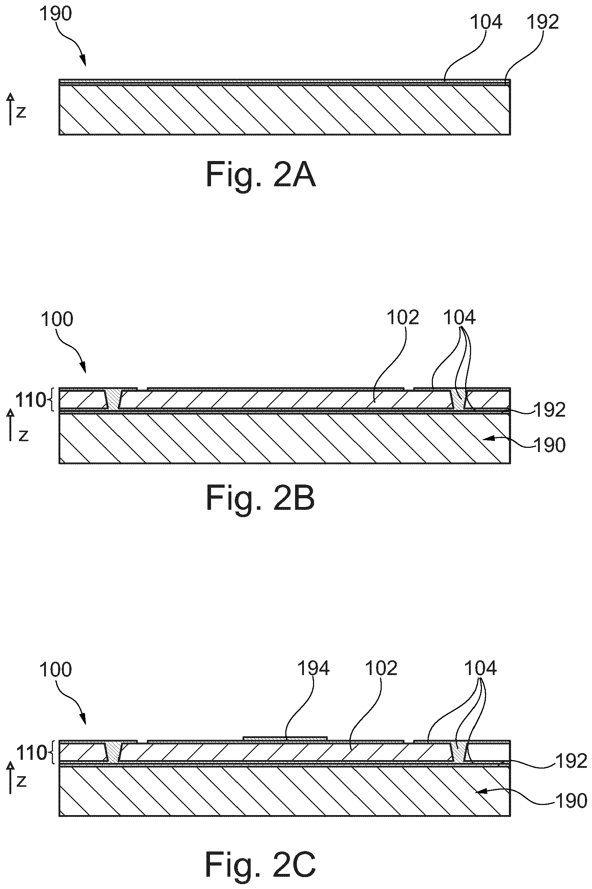

As mentioned above, Figure 2A to Figure 4C illustrate cross-sectional views of structures obtained during carrying out sequences of a method of manufacturing a component carrier according to an exemplary embodiment of the invention above described and shown in Figure 1.

Referring to Figure 2A, an electrically conductive layer structure 104 is attached to a temporary carrier structure 190. Said temporary carrier structure 190 may be a plate-like structure comprising glass and/or organic polymeric material. Additionally, on one main surface of the temporary carrier structure 190 may comprise a temporary adhesive layer 192. Preferably, the temporary carrier structure 190 and/or the temporary adhesive layer 192 may comprise adhesive properties. Optionally, the temporary adhesive layer 192 may change, in particular reduce, its adhesive properties when exposed to elevated temperatures, for example higher than 60 °C, and/or electromagnetic waves, for example in the range from 100 nm to 450 nm. Alternatively, the temporary adhesive layer 192 may comprise or consist of electrically conductive material, for example a metal. Preferably, the temporary adhesive layer 192 may be in direct contact with the electrically conductive layer structure 104.

Referring to Figure 2B in addition to Figure 2A an electrically insulating layer structure 102 and an electrically conductive layer structure 104 are provided to the electrically conductive layer structure 104 of Figure 2A such, that the layer structures are stacked one above each other in stacking direction Z. Thereby, the electrically insulating layer structure 102 is in direct contact with the two electrically conductive layer structures 104. In other words, the electrically insulating layer structure 102 is sandwiched between two adjacent electrically conductive layer structures 104. The electrically conductive layer structures 104 and the electrically insulating layer structure 102 may be mechanically connected by a pressing process, for example by exposing the layer structures to elevated temperature, for example higher than 60 °C, and/or elevated pressure, for example higher than 1.5 bar. The stacked electrically conductive layer structures 104 and the electrically insulating layer structure 102 may form the stack 110. The exposed electrically conductive layer structure 104 may be structured in order to form electrically conductive tracks. In an embodiment, structuring of electrically conductive layer structures 102 may use at least one material removal process known in the art, for example wet chemical etching processes and/or plasma processes. Additionally or alternatively, other processes may be used. Preferably, the exposed electrically conductive layer structure 104 may be electrically connected to the other electrically conductive layer structure 104 by at least one electrically conductive vertical connection.

Referring to Figure 2C in addition to Figure 2B, a temporary aid structure 194 is provided to the stack 110. Preferably, the temporary aid structure 194 may be in direct contact with the exposed electrically conductive layer structure 102. The temporary aid structure 194 may comprise electrically insulating material and/or organic material. Additionally or alternatively the temporary aid structure 194 may comprise repulsive properties towards an electrically insulating layer structure 102 and/or may be in direct contact with an electrically conductive layer structure 104 and/or may be in direct contact with an electrically insulating layer structure 102. The temporary aid structure 194 may be applied by a dispensing process. Additionally or alternatively, other process steps may be used to provide the temporary aid structure 194, for example 3-D printing.

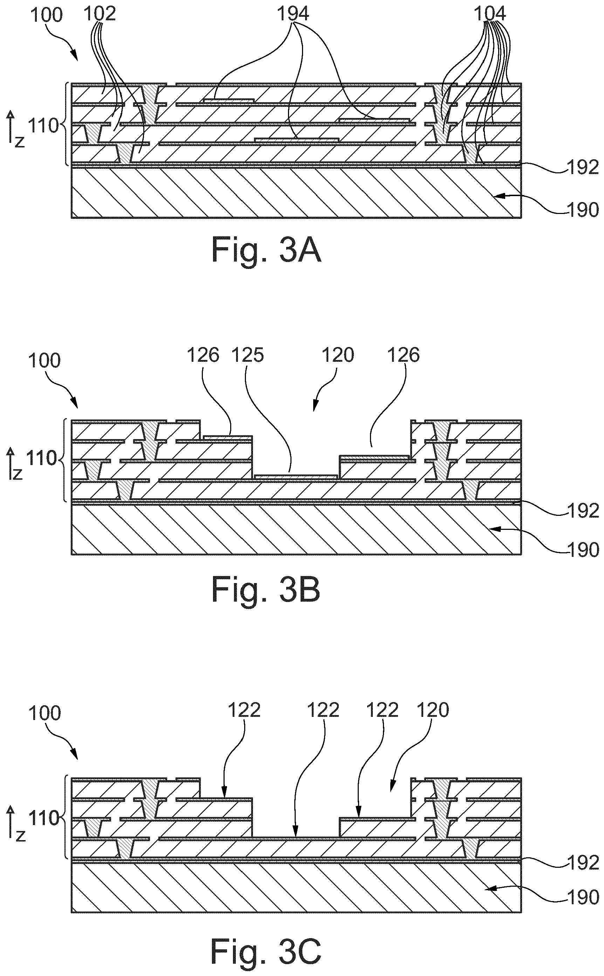

Referring to Figure 3A the sequence described in Figure 2B and Figure 2C may be repeated in order to provide a plurality of electrically insulating layer structures 102 and a plurality of electrically conductive layer structures 104 one above the other. Thereby, the electrically insulating layer structures 102 and the electrically conductive layer structures 104 are sequenced in an alternating manner. Preferably, the respective electrically conductive layer structures 104 may be structured in order to create electrically conductive traces / pads and may be vertically interconnected with each other by (electrically conductive) vertical connections. Said plurality of electrically conductive layer structures 104 and plurality of electrically insulating layer structures 102 may create the stack 110 of the component carrier 100. Additionally, the stack 110, in particular at least two electrically insulating layer structures 102, in this shown example three electrically insulating layer structures 102 may comprise a temporary aid structure 194.

Referring to Figure 3B additionally to Figure 3A a cavity 120 is formed inside the stack 110. The cavity 120 may have a bottom wall 122 composed of a plurality of portions 125, 126 each having a respective vertical level regarding stacking direction Z. At least a portion 125, 126, in particular at least a plurality of portions 125, 126, of cavity 120 and/or the bottom wall 122 may be delimited by the temporary aid structure 194. Preferably, the cavity 120 may be formed by a laser process, for example by use of an CO2 laser. Alternatively, a mechanical drilling process and/or a mechanical routing process and/or fluid jet cutting and/or another laser tool can be used for the cavity 120 formation, for example an excimer laser. During cavity formation, in particular when using a laser process, at least a portion, in particular a plurality of portions, of electrically conductive layer structures 104 are exposed. In top view (not shown), the cavity 120 may comprise a closed circumference, wherein in the inside of the cavity the temporary aid structure 194 is located. Preferably, at least two of the respective electrically conductive layer structures 104 of plurality of exposed portions (created by the laser process) may be located at different vertical levels regarding stacking direction Z of the stack 110. A portion of the stack 110, which is delimited by the circumference of the cavity 120 in lateral direction and located above the temporary aid structure 194 in stacking direction Z, may be mechanically removed to create (the biggest portion of the volume of) the cavity 120. The temporary aid structure 194, may simplify the mechanical removal of the portion of the stack 110 to create the cavity 120, since the temporary aid structure 194 may have week adhesive interaction toward the adjacent electrically insulating layer structure 102.

Referring to Figure 3C additionally to Figure 3B, the temporary aid structure 194 may be at least partially, in particular fully, removed. This process step(s), may create a cavity 120, wherein the plurality of portions 125, 126 defines a stepped cavity bottom wall 122. In an example, a portion of the sidewall, which vertically connects two portions 125, 126 of the bottom wall 122, may be parallel to the stacking direction Z. Alternatively a portion of the sidewall, which vertically connects two portions 125, 126 of the bottom wall 122, may be inclined with regard to the stacking direction Z. The direction of the portion of the sidewall may depend on the manufacturing process. Preferably, at least a portion of the sidewall of the cavity 120 may comprise electrically insulating material of at least one, in particular at least two, electrically insulating layer structure 102. Additionally or alternatively, at least a portion of the sidewall of the cavity 120 may comprise electrically conductive material of at least one, in particular at least two, electrically conductive layer structures 104. In an example, a deepest 125 of the plurality of portions may have the highest surface extension in a planar view. In another example, the deepest 125 of the plurality of portions is circumferentially connected to other portions 126 of the cavity 120 wherein the bottom walls 122 of the portions 125, 126 having different vertical levels. As shown in Figure 3C, the respective other portions 126 comprise a respective bottom wall 122located at different vertical levels regarding stacking direction Z. Additionally, the deepest portion 125 is preferably delimited by a main surface of one of the plurality of conductive structures 104. Additionally or alternatively, at least one of the other portions 126 may be delimited by a main surface of one of the plurality of electrically conducting layer structures 104. Preferably, the manufacturing process may interconnect the plurality of portions 125, 126 to create the cavity 120.

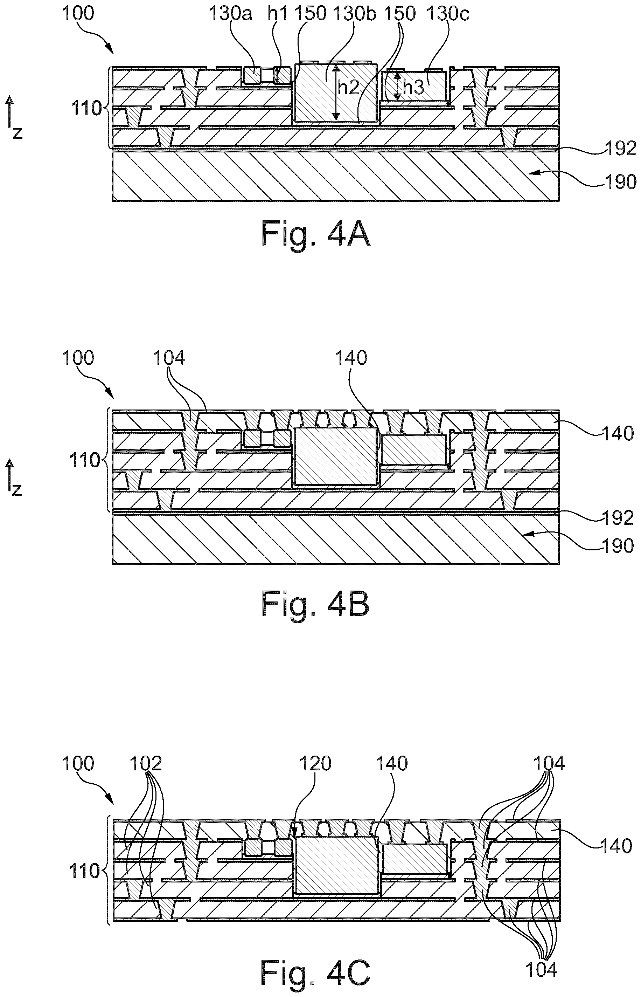

Referring to Figure 4A, additionally to Figure 3C three components 130a, 130b, 130c are provided in the cavity 120. Preferably, the components 130a, 130b, 130c have different vertical heights h and are associated to one respective portion 125, 126. Preferably, at least one adhesive material 150 may be located in the cavity 120. For example, the adhesive material 150 may be in direct contact with the bottom wall 122 and/or the plurality of portions 125, 126. Additionally, the adhesive material 150 may be in direct contact with a respective component 130a, 130b, 130c. In an example, the adhesive material 150 may be provided on the bottom wall 122, for example by a dispensing process. Afterwards the component 130a, 130b, 130c may be placed on the before provided adhesive material 150. Additionally or alternatively, the adhesive material 150 may be located on a main surface of a component 130a, 130b, 130c. The component 130a, 130b, 130c comprising the adhesive material 150 attached on one surface of the component may be provided into the cavity 120 such that, the adhesive material 150 may be located between the bottom wall 122 and the component 130a, 130b, 130c. In an example, the adhesive material may comprise an organic material, in particular a polymeric organic material. In an example, at least one of the components 130a, 130b, 130c in the at least one of the other portions 126 may comprise a capacitor and/or a bridge (component). In another example, at one of the components 130a, 130b, 130c in the deepest 125 of the plurality of portions comprises a chip and/or an interposer and/or a block. Preferably, the plurality of components 130 may be located such, that the connection terminal and/or the connection surface of the respective components 130 may be opposed to the side of the component where the adhesive material 150 is located. Preferably, one component 130a, 130b, 130c may be associated to one portion, in particular the deepest portion 125 and/or the other portion 126. Alternatively, at least two components may be associated to one portion, in particular the deepest portion 125 and/or the other portion 126. Still in a further example, the space may be located between the (sidewall of the) cavity 120 and the respective components 130. In an example, the space between one of the other portions 126 and the respective one of the plurality of components 130 may be different than the space between the deepest 125 of the plurality of portions and one of the plurality of components 130 in said portion 124. In a further example, the components 130 may be adjacent one to the other.

Referring to Figure 4B, additionally to Figure 4A an encapsulating layer structure 140 and a further electrically conductive layer structure 104 are provided on top of the electrically conductive layer structure 104 and the electrically insulating layer structure 102 and the components 130a, 130b, 130c of Figure 4A such that the further electrically conductive layer structure 104 may be exposed and that the encapsulating layer structure 140 may be sandwiched between the further electrically conductive layer structure 104 and the electrically conductive layer structure 104 and/or electrically insulating layer structure 102 and/or component 130 of Figure 4A. After a lamination process, for example by application of temperatures higher than 60 °C and/or pressure higher than 1.5 bar, the stack 110 may be expanded by the further electrically conductive layer structure 104 and the encapsulant layer structure 140. The lamination process may at least partially, in particular fully, allow the filling of the space between the respective component 130 and the sidewall of the cavity 120 with encapsulant material of the encapsulating layer structure 140. The encapsulant material 140 may be in direct contact with at least one, in particular at least two, electrically insulating layer structures 102 and/or at least one, in particular at least two, electrically conductive layer structures 104 and/or at least one, in particular at least two, adhesive materials 150 and/or at least one, in particular at least two, components 130. Additionally, the encapsulant material 140 may fill a space between two lateral adjacent components 130, for example the space between the first component 130a and the second component 130b. The components 130a, 130b, 130c have different vertical heights h and are associated to one respective portion 125, 126, such that the surfaces of said components 130 opposed to the bottom wall 122 of the cavity 120 are vertically positioned within the vertical extension of the same external layer structures 102, 104. Optionally, the further electrically conductive layer structure 104 may be structured in order to create electrically conductive traces. Additionally or alternatively, the further electrically conductive layer structure 104 may be vertically connected to at least one of the plurality of electrically conductive layer structures 102 by electrically conductive vertical connections. Preferably, the further electrically conductive layer structure 104 may be connected to at least one connection terminal and/or connection surface of at least one, in particular at least two, more in particular to all, respective components 130 by at least one, in particular a plurality, of electrically conductive vertical connections.

Referring to Figure 4C, additionally to Figure 4B the temporary carrier structure 190 is removed from the stack 110. Preferably, the temporary carrier structure 190 and/or the stack 110 may be exposed to elevated temperatures, for example higher than 60 °C, and/or electromagnetic waves, for example in the range from 100 nm to 450 nm, thereby, the adhesion between the temporary carrier structure 190 (comprising the temporary adhesive layer 192) may be reduced resulting in a damage-less removal of the temporary carrier structure 190 from the stack 120. Additionally or alternatively, other processes may be used known in the art to remove the temporary carrier structure 190. Preferably, no residues of the temporary carrier structure 190 may be left on the exposed surface of the stack 110. Optionally, the electrically conductive layer structure 102, which is now exposed and was attached to the temporary carrier structure 190, may be structured. Optionally, the at least one of the two exposed main surfaces of the stack 110 may be subjected to further process steps, for example to provide a surface finish and/or a solder resist as could be seen in Figure 1.

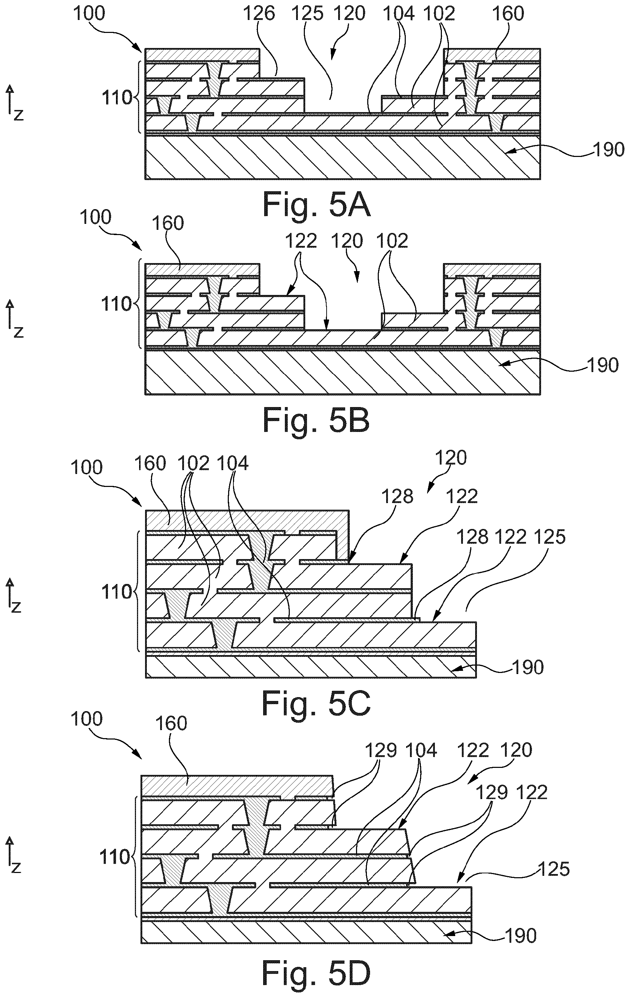

Figures 5A to 6C illustrate cross-sectional views of structures obtained during carrying out sequences of a method of manufacturing a component carrier according to a further exemplary embodiment, starting from the above described step shown in Figure 3C.

Referring to Figure 5A additionally to Figure 3C a mask material 160 is provided on the exposed layer(s) of the stack 110 opposite to the temporary carrier structure 190. Preferably, the cavity 120, in particular the circumference of the cavity and/or the inward of the cavity, may not be covered by the mask material 160. Optionally at least a part of a portion 125 126 of the cavity 120 may be covered by the mask material 160 (see Figure 5C).

Referring to Figure 5B additional to Figure 5A a material removal process step is applied. Thereby, the material removal process step may remove the exposed electrically conductive layer structure 104 and/or the material of the stack 110 being not covered by the mask material 160. Preferably, the electrically conductive layer structure 104 inside the cavity 120 may be removed. The material removal process step may expose the electrically insulating layer structure(s) 102 at the bottom wall 122 of the plurality of portions 125, 126. The deepest portion 125 of the shown embodiment is delimited by a main surface of one of the plurality of electrically insulating structures 102. Additionally or alternatively, the other portions 126 are delimited by a main surface of one of the plurality of electrically insulating layer structures 102. In a not shown alternative, the deepest portion 125 may be delimited by a main surface of one of the plurality of electrically insulating structures 102 whereas at least one of the other portions 126 may be delimited by a main surface of one of the plurality of electrically conductive layer structures 104. In another example, the material removal process step may comprise a wet chemical etching step. Additionally or alternatively, the material removal process step may comprise other chemical process steps and/or physical process steps, for example plasma etching.

Figure 5C which is a magnified view the left part of Figure 5B, showing that the material removal process step only partially removed the exposed electrically conductive layer structure 104 (inside the cavity). A stepped portion 128, 129 between the lateral wall and the bottom wall 122 of the cavity 120 is the result of said partial removal, in particular said stepped portion 128, 129 being delimited by one main surface of an insulating structure 102. In an example, said stepped portion may comprise a protrusion 128 extending into the cavity 120. The lateral extension of the protrusion 128 may depend of the used process parameters of the material removal process. Additionally or alternatively, the extension of the protrusion 128 may depend on fluid flow mechanics when wet chemical etching step is used and/or if the electrically conductive layer structure 102 affiliated to the protrusion 128 is covered by a mask material 160.

Figure 5D which is another magnified view of the left part of 5B formed with different process steps. The cavity 120 has inclined sidewall (portions). This product feature may be created due to the use of a laser process to form the lateral wall of the cavity/portion(s). The sidewall of the cavity portion 125, 126 may be inclined inwardly towards the bottom wall 122 of the cavity 120 regarding stacking direction Z. In an example, the respective portions 125, 126 of the cavity 120 may have different inclinations. Additionally, as can be seen, at least one stepped portion 128, 129 may be provided. The stepped portion may comprise a recess 129 extending from to cavity 120. The recess 129 by be an under-etch created by a wet chemical etching step and/or by a removal of a temporary aid structure 194 having a planar extension greater than the planar extension of the respective portion.

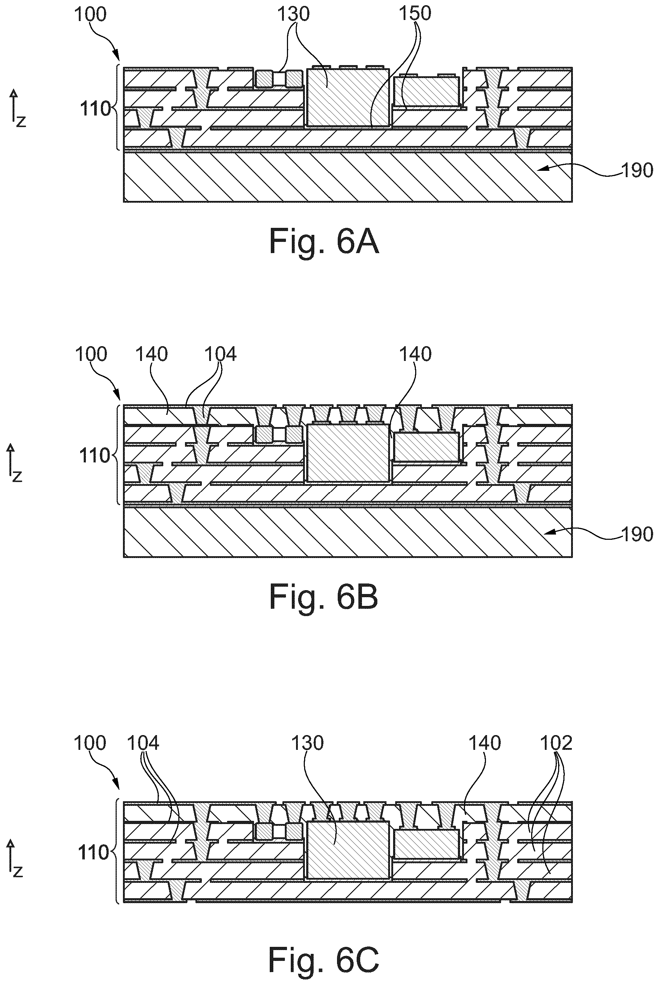

Referring to Figure 6A additional to Figure 5A the mask material 160 is removed, for example by a stripping process. This may expose the adjacent layer structure, in particular the electrically conductive layer structure 104 and/or the electrically insulating layer structure 102. In comparison to Figure 4A, at least a part of the bottom wall 122 of the at least one respective portion 125, 126 comprises one of the plurality of electrically insulating layer structure 102. Three of components 130a, 130b, 130c is provided in the cavity 120. Compared to Figure 4A at least one adhesive material 150 may be in direct contact with an electrically insulating layer structure 102. In particular, a plurality of adhesive materials 150 may be located at a respective bottom wall 122 of a respective portion 124.

Referring to Figure 6B additional to Figure 6A, an encapsulant material 140 is provided at the stack 110 as described for Figure 4B. Similar to Figure 4B, the encapsulant material 140 may fully fill the space between the sidewall of the cavity 120 and the plurality of components 130. Additionally or alternatively, the encapsulant material 140 may (fully) fill the space between the respective components 130. This may ensure a reliable embedding of the plurality of components 130 in the cavity 120. Preferably, the further electrically conductive layer structure 104 may be structured and connected to the connecting surface and/or connecting terminal of the respective components 130.

Referring to Figure 6C additional to Figure 6B, the temporary carrier structure 190 is removed. The electrically conductive layer structure 104 which was in contact with the temporary carrier structure 190 may be structured in order to create electrically conductive tracks. Optionally, the at least one of the two exposed main surfaces of the stack 110 may be subjected to further process steps, for example to provide a surface finish and/or a solder resist as could be seen in Figure 1.

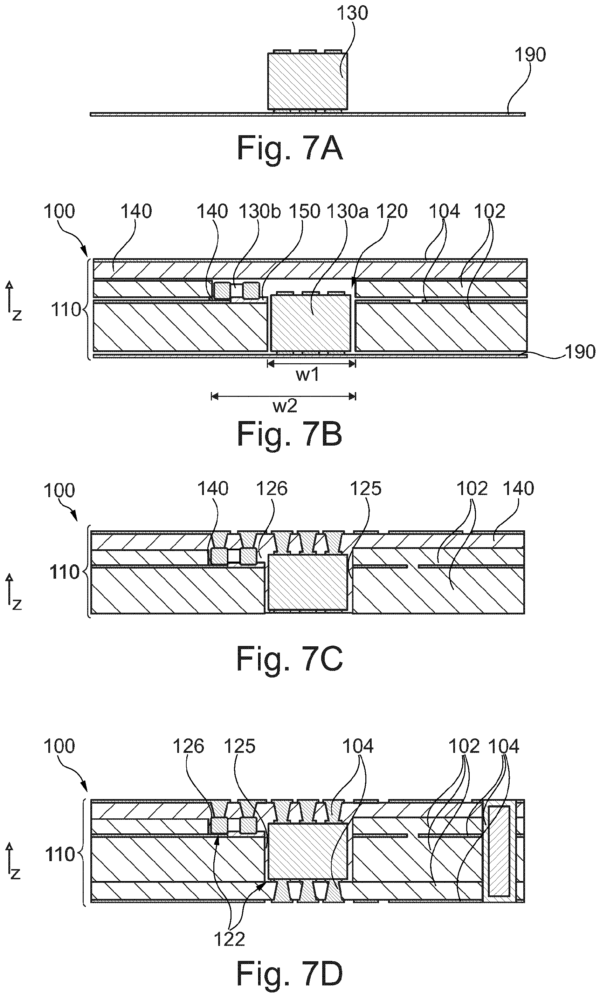

As mentioned above, Figure 7A to Figure 7D illustrate cross-sectional views of structures obtained during carrying out sequences of a method of manufacturing a component carrier according to a further exemplary embodiment of the invention.

Referring to Figure 7A, a component 130 is provided on a temporary carrier structure 190. The component 130 may comprise a plurality of connecting surfaces and/or connection terminal at both main surfaces of the component 130. In an example, the component 130 may be in direct contact with a plurality of connecting surfaces and/or connecting terminals of one main surface with the temporary carrier structure 190. In another example, the temporary carrier structure 190 may be a plate shaped temporary adhesive layer 192.

Referring to 7B, an exploded view of different layer structures of the stack 110 are shown. On the bottom, the temporary carrier structure 190 with the provided first component 130a is shown. Additionally, an electrically insulating layer structure 102 is shown. The electrically insulating layer structure 102 may comprise a structured electrically conductive layer structure 104 on one of its main surface. Preferably, the electrically insulating layer structure 102 comprises an organic polymeric material, for example poly epoxy resin, which has a high curing degree and/or curing state, for example a core material. Further additionally, the electrically insulating layer structure 102 may comprise a cavity (formed through the entire thickness of the layer regarding stacking direction Z) with a width w1 in lateral direction. Preferably, the width w1 of the cavity of the electrically insulating layer structure 102 may be bigger than the width of the first component 130a (which is attached to the temporary carrier structure 190). An adhesive material 150 may be provided at one main surface of the electrically insulating layer structure 102, preferably, the main surface at which the electrically conductive layer structure is provided. Optionally, the adhesive material 150 may be in direct contact with the electrically conductive layer structure 104. An encapsulant material 140, may be provided at the electrically insulating layer structure 102, in particular at the electrically conductive layer structure 102 associated to the electrically insulating layer structure 102. The encapsulant material 140 may be in (direct) contact with the adhesive material 150. Preferably, the encapsulant material 140 may have electrically conductive properties and/or the adhesive material 150 may have electrically insulating properties. Optionally the electrically conductive layer structure 104 may be in direct contact with the adhesive material 150, the encapsulant material 140 and the electrically insulating material 102. A second component 130b may be provided at one main surface of the electrically insulating layer structure 102. Preferably, the second component 130b may be in direct contact with the adhesive material 150 and/or the encapsulant material 140. Preferably, only the electrically insulating layer structure 102 may be adjacent to the temporary carrier structure 190. In other word, the second component 130b, and/or the adhesive material 150 and/or the encapsulant material 140 and/or the electrically conductive layer structure 102 may be located on the opposed main surface of the electrically insulating layer structure 102 compared to the main surface of the electrically insulating layer structure 102 which is adjacent to the temporary carrier structure 190. A further electrically insulating layer structure 102 may be provided. The further electrically insulating layer structure 102 may comprise a cavity (formed through the entire thickness of the layer regarding stacking direction Z) having a width w2. Preferably, the width w2 of the cavity of the further electrically insulating layer structure 102 may be larger than the width w1 of the cavity of the electrically insulating layer structure 102. In particular, the width w2 of the cavity of the further electrically insulating layer structure 102 may be larger than the lateral extension of the first component 130a and the lateral extension of the second component 130b. Additionally, an encapsulant layer structure 140 comprising a further electrically conductive layer structure 104 may be provided. The encapsulant layer structure 140 may be provided such that the electrically conductive layer structure 104 may be exposed.

Referring to Figure 7C, a lamination process step may be applied in order to mechanically connect the materials and/or layer structures 102, 104 and/or components 130 of Figure 7B and/or create the stack 110. The lamination process step may create the cavity 120 having a bottom wall 122 composed of a plurality of portions 125, 126 each having a respective vertical level by connecting the cavity of the electrically insulating layer structure 102 with the cavity of the further electrically insulating layer structure 102. Additionally or alternatively, the lamination process may provide encapsulant material 140 (of the encapsulant layer structure) into the cavity 120. Additionally, the exposed further electrically conductive layer structure 104 may be structured, for example by a material removal process step, in order to create electrically conductive traces, for example copper traces. Additionally or alternatively, electrically conductive vertical connections may be provided in the encapsulant layer structure 140 to mechanically and/or electrically connect the exposed electrically conductive layer structure 104 with the connecting surface and/or connecting terminal of at least one component. Preferably, the connecting surface and/or connecting terminal of components 130 facing away from the temporary carrier structure 190 may be connected with the exposed further electrically conductive layer structure 104. In an example, the second component 130b may be electrically connected at two sides. On one side, the second component 130b may be electrically connected to one of the plurality of electrically conductive layer structures 104 by the (electrically conductive) encapsulant material 140 and on the other side, the second component may be electrically connected to another one of the plurality of electrically conductive layer structures 104 by the (electrically conductive) vertical connection. Additionally, the temporary carrier structure 190 is removed.

Referring to Figure 7D, additional to Figure 7C, another electrically insulating layer structure 102 comprising another electrically conductive layer structure 104 is provided by another lamination process step. In an example, the stack 110 may be enlarged by the other electrically conductive layer structure 104 and the other electrically insulating layer structure 102. The other electrically insulating layer structure 102 may be provided such that it is in direct contact with the electrically insulating layer structure 102. Additionally, the other electrically conductive layer structure 104 may be exposed. In order word, the other electrically insulating layer structure 102 may be sandwiched between the electrically insulating layer structure 102 and the other electrically conductive layer structure 104. This may create the cavity 120 having a bottom wall 122 composed of a plurality of portions 125, 126 having a respective vertical level, and being delimited by one main surface of one of said plurality of electrically conductive layer structures 104 or electrically insulating layer structures 102 composing the stack 110. The other electrically conductive layer structure 104 may be electrically connected to the connecting surface and/or connecting terminals by (electrically conductive) vertical connection and/or may be further structured. Additionally, an electrically conductive vertical connection may electrically connect the two exposed surfaces of the stack 110. Optionally, the at least one of the two exposed main surfaces of the stack 110 may be subjected to further process steps, for example to provide a surface finish and/or a solder resist as could be seen in Figure 1.

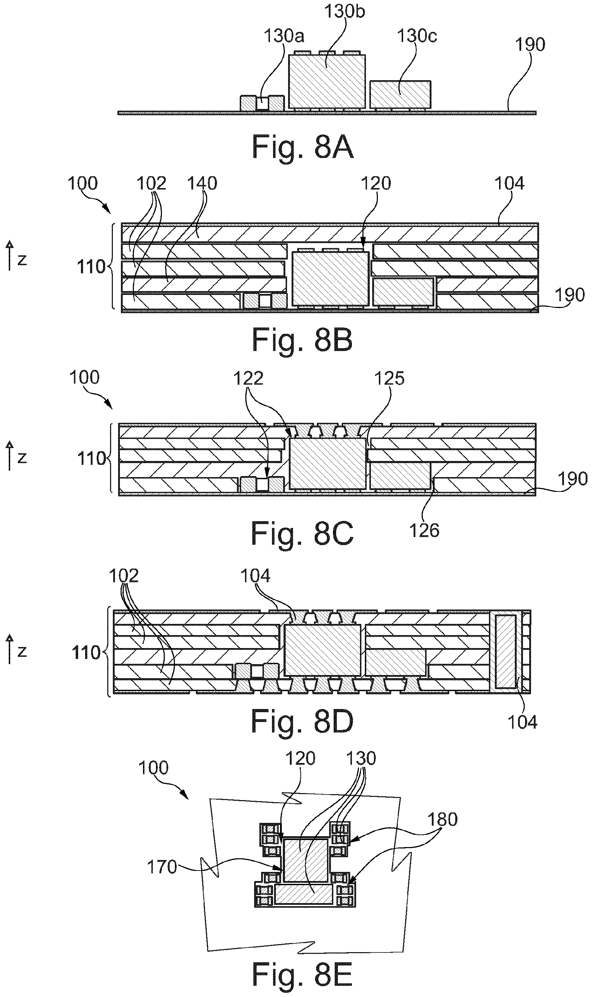

As mentioned above, Figure 8A to Figure 8D illustrate cross-sectional views of structures obtained during carrying out sequences of a method of manufacturing a component carrier according to a further exemplary embodiment of the invention.

Referring to Figure 8A, a plurality of components 130, in particular a first component 130a, a second component 130b and a third component 130c, are provided on a temporary carrier structure 190. Preferably, at least two of the components 130 may have respective different (vertical) heights. Each of the components 130 may comprise a respective plurality of connecting surfaces and/or connecting terminals located on one main surface. Preferably, the respective connecting surfaces and/or connecting terminals may be in direct contact with the temporary carrier structure 190. Optionally, at least one of the components 130, in particular the component 130 having the largest height, may have a further plurality of connecting terminals and/or connecting surfaces located on the opposed other main surface.

Referring to Figure 8B, an exposed view of different layer structures of the stack 110 are shown. In particular, a plurality, in particular three, of electrically insulating layer structures 102 are and a plurality, in particular two, of encapsulant layer structures 140 are provided. The encapsulant layer structures 140 may not fully hardened and/or cured. Preferably, at least two, in particular all, electrically insulating layer structures 102 may comprise a cavity formed through the entire thickness of the layer regarding stacking direction Z. Preferably, the cavity may have a width larger than lateral extension of the first component 130a and/or lateral extension of the second component 130b and/or lateral extension of the third component 130c. At least one of the encapsulant layer structures 140 may comprise a further cavity formed through the entire thickness of the layer regarding stacking direction Z. Preferably, the further cavity may have a width larger than lateral extension of the first component 130a and/or lateral extension of the second component 130b and/or lateral extension of the third component 130c. At least one encapsulant layer structure 140 may be arranged between two electrically insulating layer structures 102 regarding stacking direction Z. Preferably, the electrically insulating layer structures 102 and the encapsulant layer structures 140 may be arranged such that the cavities and/or further cavity may at least partially overlap with each other. Thereby, the side walls of the respective cavities and/or further cavity may be aligned to form a substantially straight common sidewall. Preferably, one of the encapsulant layer structures 140 may comprise an electrically conductive layer structure 104 and may be located such that the electrically conductive layer structure 104 is exposed. Said encapsulant layer structure 140 may be free from a further cavity and may cover a cavity from an adjacent electrically insulating layer structure 102. Optionally, between the electrically insulating layer structures 102 and the encapsulant layer structures 140 regarding stacking direction Z an electrically conductive layer structure 104 may be located. Further optionally, two electrically insulating layer structures 102 may be adjacent one to each other. Preferably, the cavity of the electrically insulating layer structure 102 and/or the cavity of the encapsulant layer structure 140 may be from by a laser cutting process and/or a mechanical drilling process.

Referring to Figure 8C, a lamination process step may be applied in order to mechanically connect the materials and/or layer structures 102, 104 and/or components 130 of Figure 8B and/or create the stack 110. The lamination process step may create the cavity 120 having a bottom wall 122 composed of a plurality of portions 125, 126 each having a respective vertical level being delimited by one main surface of one of said plurality of electrically conductive layer structures 104 or electrically insulating layer structures 102 by connecting the cavity of the electrically insulating layer structure 102 with the cavity of the further electrically insulating layer structure 102 and/or with the further cavity of the encapsulant layer structure 140 (composing the stack 110). Additionally or alternatively, the lamination process may provide encapsulant material 140 (of the encapsulant layer structure) into the cavity 120. During the lamination process, due to the elevated temperatures, the encapsulant layer structure 140 may become flowable. The temporarily flowable encapsulant material 140 may embed said plurality of components. One of the encapsulant layer structures 140 may provide the encapsulant material 140 from a lateral side to fill up the cavity 120. Additionally or alternatively, the encapsulant layer structure 140 may provide the encapsulant material 140 from a side parallel to stacking direction Z to fill up the cavity 120. As explained by Figure 8B and Figure 8C forming each of the portions 125, 126 having different levels may be done in respective manufacturing steps. Additionally, the exposed electrically conductive layer structure 104 may be structured, for example by a material removal process step, in order to create electrically conductive traces, for example copper traces. Additionally or alternatively, electrically conductive vertical connections may be provided in the encapsulant layer structure 140 to mechanically and/or electrically connect the exposed electrically conductive layer structure 104 with the connecting surface and/or connecting terminal of at least one component. Preferably, the connecting surface and/or connecting terminal of components 130 facing away from the temporary carrier structure 190 may be connected with the exposed further electrically conductive layer structure 104.

Referring to Figure 8D, additional to Figure 8C, the temporary carrier structure 190 is removed. Additionally, another electrically insulating layer structure 102 comprising another electrically conductive layer structure 104 is provided by another lamination process step. In an example, the stack 110 may be enlarged by the other electrically conductive layer structure 104 and the other electrically insulating layer structure 102. The other electrically insulating layer structure 102 may be provided such that it is in direct contact with the electrically insulating layer structure 102. Additionally, the other electrically conductive layer structure 104 may be exposed. In order word, the other electrically insulating layer structure 102 may be sandwiched between the electrically insulating layer structure 102 and the other electrically conductive layer structure 104. The other electrically conductive layer structure 104 may be electrically connected to the connecting surface and/or connecting terminals of the first component 130a and/or the second component 130b and/or the third component 130c by (electrically conductive) vertical connection. The vertical connection connecting the connecting surface and/or connecting terminals of the first component 130a and/or the second component 130b and/or the third component 130c may have the same dimensions. Since the respective components 130 are located on a shared common vertical level, the respective vertical connections can be manufactured within one process step using only one registration regarding the direction parallel to stacking direction Z. This may simplify the manufacturing process of the respective vertical connections and reduce the risk of damaging the connecting surfaces of the respective components 130 by for example a laser process. Additionally or alternatively, the other electrically conductive layer structure 104 may be further structured. Additionally, an electrically conductive vertical connection may electrically connect the two exposed surfaces of the stack 110. Optionally, the at least one of the two exposed main surfaces of the stack 110 may be subjected to further process steps, for example to provide a surface finish and/or a solder resist as could be seen in Figure 1.

Referring to Figure 8E, a further example of a component carrier 100 according to the first aspect of the present invention is shown. A top view, in particular a cross sectional top view, of the component carrier 100 is shown. The component carrier 100 may be a semi-finished component carrier as shown in Figure 4A. A plurality of components 130 are located in the central portion of the component carrier 100. The plurality of components 130 may be surrounded by the cavity 120. Preferably, the cavity 120 has an irregular shape (in planar view). Alternatively, the cavity 120 has a regular shape (in planar view). In an example, the contour of the cavity 120 may follow the contour of the plurality of components 130. In a further example, the cavity 120 can have a stepped shape (in planar view). In another example, the cavity 120 in planar view may define a central core 170 from that at least one branch 180 merges. Preferably, the central core 170 may be associated with the deepest portion 125 of the cavity 120 and/or the at least one branch 180 may be associated with the other portion 126 of the cavity. In an example, one component 130 may be located at the central core 170 of the cavity 120. Alternatively, a plurality of components 130 may be located at the central core 170 of the cavity. In another example, one component 130 may be located at the branch 180 of the cavity 120. Alternatively, a plurality of components 130 may be located at the branch 180 of the cavity. Preferably, at least two branches 180 may merge into the central core 170. Such a design of the cavity 120 may particularly create the volume of the cavity 120 slightly bigger than the plurality of components 130. This may reduce the encapsulant material 140 needed to fully fill the space between the sidewall of the cavity 120 and the plurality of components 130 and/or the respective components 130. Additionally or alternatively, this may bring the advantage that the encapsulant material 140 flowing in the other portions 180 during the embedding of the respective components may contribute to fill the (higher) volume between the deepest 125 of the plurality of portions and the inserted component. This may bring the advantage that the branches 180 acts as flowing channels of encapsulant material 140 around the core 170 during the embedding of the respective components, enhancing the filling reliability of the (higher) volume to fill in the core.

It should be noted that the term "comprising" does not exclude other elements or steps and the "a" or "an" does not exclude a plurality. Also, elements described in association with different embodiments may be combined.

Implementation of the invention is not limited to the preferred embodiments shown in the figures and described above. Instead, a multiplicity of variants is possible which use the solutions shown and the principle according to the invention, whose scope is defined by the appended claims.

### List of Reference Signs

- 100: component carrier
- 102: electrically insulating layer structure
- 104: electrically conductive layer structure
- 110: stack
- 120: cavity
- 122: bottom wall
- 125: deepest portion
- 126: other portions
- 128: protrusion of the stepped portion
- 129: recess of the stepped portion
- 130: components
- 140: encapsulant material, encapsulant layer structure
- 150: adhesive material
- 160: mask material
- 170: central core
- 180: branch
- 190: temporary carrier structure
- 192: temporary adhesive layer
- 194: temporary aid structure
- h1, h2, h3: height (of the component)
- w1, w2: width
- Z: thickness direction

## Claims

1. A component carrier, wherein the component comprises:
a stack comprising a plurality of electrically conductive layer structures and a plurality of electrically insulating layer structures, said stack further comprising a cavity having a bottom wall composed of a plurality of portions having a respective vertical level, and being delimited by one main surface of one of said plurality of electrically conductive layer structures or electrically insulating layer structures composing the stack;
a plurality of components provided in said cavity, at least two of said components having different heights one to each other and each of said components being associated to one respective portion, such that the surfaces of said components opposed to the bottom wall of the cavity are vertically positioned within the vertical extension of the same external layer structures; and
an encapsulant material embedding said plurality of components.

2. The component carrier according to claim 1, wherein the plurality of portions defines a stepped cavity bottom wall.

3. The component carrier according to any of the claims 1 to 2,
wherein the component carrier comprises an encapsulant layer structure.

4. The component carrier according to any of the claims 1 to 3,
wherein a deepest of the plurality of portions has the highest surface extension in a planar view.

5. The component carrier according to any of the claims 1 to 4,
wherein the deepest of the plurality of portions is circumferentially connected to the other portions of the cavity having different vertical levels.

6. The component carrier according to any of the claims 1 to 5,
wherein the deepest portion is delimited by a main surface of one of the plurality of electrically insulating layer structures.

7. The component carrier according to claim 5 or 6, wherein at least one of the other portions is delimited by a main surface of one of the plurality of electrically conducting layer structures.

8. The component carrier according to any of the claims 1 to 7,
wherein the cavity has an irregular shape in planar view.

9. The component carrier according to any of the claims 1 to 8,
wherein the cavity has a stepped shape in planar view.

10. The component carrier according to any of the claims 4 to 9,
wherein the space between one of the other portions and the respective one of the plurality of components is different than the space between the deepest of the plurality of portions and one of the plurality of components in said portion

11. The component carrier according to any of the claims 1 to 10,
wherein a stepped portion is provided between the lateral wall and the bottom of the cavity, in particular said stepped portion being delimited by one main surface of an insulating structure, in particular wherein said stepped portion comprises a protrusion extending into the cavity or a recess extending from the cavity.

12. The component carrier according to any of the claims 1 to 11,
wherein at least two between the plurality of electrically conductive layer structures and/or the plurality of electrically insulating layer structures where the cavity extends have different thicknesses one to each other, in particular said at least two layer structures being either insulating or conductive layer structures.

13. The component carrier according to any of the claims 1 to 12,
wherein vertical connections are provided in the component carrier, a plurality of said vertical connections being electrically connected to a connection surface of a respective one of the plurality of components, wherein at least one of the vertical connections connected to the connection surface of one of the plurality of components has an extension, in a planar view, different than the respective extension of another one of the vertical connections connected to the connection surface of another one of the plurality of components.

14. The component carrier according to any of the claims 1 to 13,
wherein the cavity is prefilled with an adhesive material connecting at least one of the plurality of components.

15. A method of manufacturing a component carrier (100), wherein the method comprises:
providing a stack comprising a plurality of electrically conductive layer structures and a plurality of electrically insulating layer structures, said stack further comprising a cavity having a bottom wall composed of a plurality of portions having a respective vertical level and being delimited by one main surface of one of said plurality of electrically conductive layer structures or electrically insulating layer structures composing the stack;
providing a plurality of components in said cavity, at least two of said components having different heights one to each other and each of said components being associated to one respective portion, such that the surfaces of said components opposed to the bottom wall of the cavity are vertically positioned within the vertical extension of the same external layer structure; and
providing an encapsulant material such that said encapsulant material embeds said plurality of components.
